# EUROPEAN PATENT SPECIFICATION

(11) **EP 2 695 969 B1**
(45) Date of publication and mention of the grant of the patent: **19.08.2015**
(21) Application number: 13173104.4
(22) Date of filing: 20.06.2013
(51) Int. Cl.: C23C 14/35, H01J 37/32, H01J 37/34

(54) **Thin film deposition apparatus and method of depositing thin film using the same**
Beschichtungsvorrichtung und Verfahren zur Beschichtung eines Dünnfilms
Appareil de dépôt de film mince et procédé de dépôt de film mince

(30) Priority: 06.08.2012 KR 20120085848
(43) Date of publication of application: 12.02.2014
(73) Proprietor: Samsung Display Co., Ltd., Gyeonggi-Do (KR)
(72) Inventor: Lee, You Jong, Seoul (KR)
(74) Representative: Taor, Simon Edward William

(56) References cited:
- EP-A1- 2 178 109
- EP-A2- 0 328 076
- US-A- 5 733 418
- US-A1- 2006 196 766
- US-A1- 2007 181 421

## Description

The present disclosure relates to a thin film deposition apparatus and a method of depositing a thin film using the same. More particularly, the present disclosure relates to a thin film deposition apparatus capable of deposition a thin film using a material sputtered from a target and a method of depositing the thin film on a substrate using the thin film deposition apparatus.

In general, a sputtering apparatus applies a bias voltage to an anode and a cathode, which are disposed in a chamber, to form an electric field, and provides an inert gas influenced by the electric field into the chamber to form a plasma. Ions in the plasma are accelerated by the electric field and collide with a target to sputter the target. In this case, the bias voltage applied to the anode and the cathode has a high voltage level that is higher than a specific value to form the plasma from the inert gas.

When the bias voltage has the high voltage level, the energy of the ions in the plasma is increased as the value of the bias voltage is increased, and some of the ions in the plasma are provided to the substrate according to circumstances. For instance, in the case that the plasma is formed from the inert gas containing argon atoms, positive argon ions are accelerated by the bias voltage and collide with the target, colliding with a solid chemical element of the target so as to sputter the solid chemical element or to be reduced to neutral argon atoms. In this process, the neutral argon atoms have energy of about 20eV and are provided toward the substrate after being collided with the target, and the solid chemical element sputtered from the target has energy of about 10 eV while being provided to the substrate.

As another example, in the case that the plasma is formed from the inert gas containing oxygen or the target contains oxygen and the solid chemical element, negative oxygen ions generated from the oxygen at a surface of the target are accelerated by the bias voltage. The negative oxygen ions have energy of about 100 eV to about 400 eV while being provided to the substrate.

As described above, when the high energy materials, e.g., neutral argon atoms, negative oxygen ions, etc., are provided to the substrate, a thin film previously formed on the substrate is damaged by the high energy materials. Particularly, in the case that the thin film is an organic layer that serves as an emitting layer for an organic light emitting diode, a carbon bond in the organic layer can be broken by the neutral argon atoms or the negative oxygen ions provided to the substrate since a bonding energy, e.g., about 10 eV, of the carbon is smaller than the energy of the neutral argon atoms or the negative oxygen ions. Therefore, defects occur on the organic layer when the thin film is deposited on the organic layer using the sputtering apparatus.

Ep2178109 discloses a plasma processing method in which sputtered particles from a target by plasma are deposited on a surface of a substrate, and are decomposed by a plasma to thus generate active species, and then deposited on the surface of the substrate.

US5733418 discloses a method for sputtering particles from a target as a film on a substrate. The target and substrate are maintained in a main housing in a first vacuum. The target is biased with a first negative voltage to effect a target bias.

US2007181421 discloses a sputtering system in which a plurality of plasma sources is provided in a reaction chamber to dissociate at least one reactive gas. The dissociated reactive gas is doped in a film during the deposition of the film so as to control the composition of the film.

EP0328076 discloses an ECR system with a tubular waveguide.

The present disclosure provides a thin film deposition apparatus capable of preventing defects from occurring on a layer previously formed on a substrate while a thin film is deposited on the substrate.

The present disclosure provides a method of depositing a thin film using the thin film deposition apparatus.

According to an aspect of the invention, there is provided a thin film deposition apparatus as set out in claim 1. Preferred features of this aspect are set out in claims 2 to 8.

According to another aspect of the invention, there is provided a method of depositing a thin film on a substrate using a thin film deposition apparatus as set out in claim 9.

Preferred features of this aspect are set out in claims 11 to 12.

According to the above embodiments, the sputtering unit and the plasma generating unit of the thin film deposition apparatus are independently driven from each other, and thus the bias voltage used to drive the sputtering unit may be easily reduced regardless of the voltage used to drive the plasma generating unit. Thus, particles sputtered from the target, e.g., neutral argon atoms, negative oxygen ions, etc., may be prevented from being provided to the substrate, which have excessive energy caused by the bias voltage, while the sputtering process is performed on the target. Consequently, defects may be prevented from occurring on the previously formed thin on the substrate.

The above and other advantages of the present invention will become readily apparent by reference to the following detailed description when considered in conjunction with the accompanying drawings wherein:
FIG. 1 is a side cross-sectional view showing a thin film deposition apparatus according to an exemplary embodiment of the present invention;
FIG. 2 is a horizontal cross-sectional view showing the thin film deposition apparatus shown in FIG. 1;
FIG. 3 is a side cross-sectional view showing a thin film deposition apparatus according to another exemplary embodiment of the present invention;
FIG. 4 is a horizontal cross-sectional view showing the thin film deposition apparatus shown in FIG. 3;
FIG. 5 is a side cross-sectional view showing a thin film deposition apparatus according to another exemplary embodiment of the present invention;
FIG. 6 is a flowchart showing a method of depositing a thin film on a substrate according to an exemplary embodiment of the present invention;
FIG. 7A is a view showing a substrate before a thin film is deposited thereon; and
FIG. 7B is a view showing a substrate after a thin film is deposited thereon.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms, "a", "an" and "the" are intended to include the plural forms as well, unless the context clearly indicates otherwise. It will be further understood that the terms "includes" and/or "including", when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, the present invention will be explained in detail with reference to the accompanying drawings.

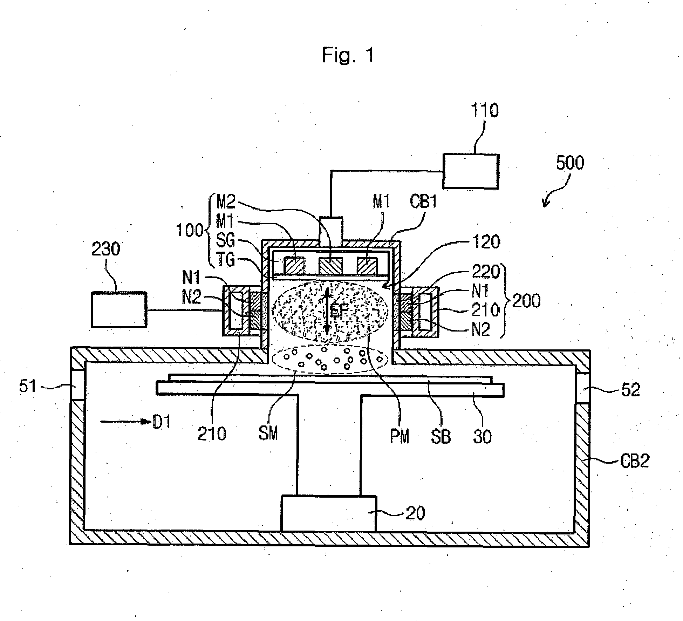

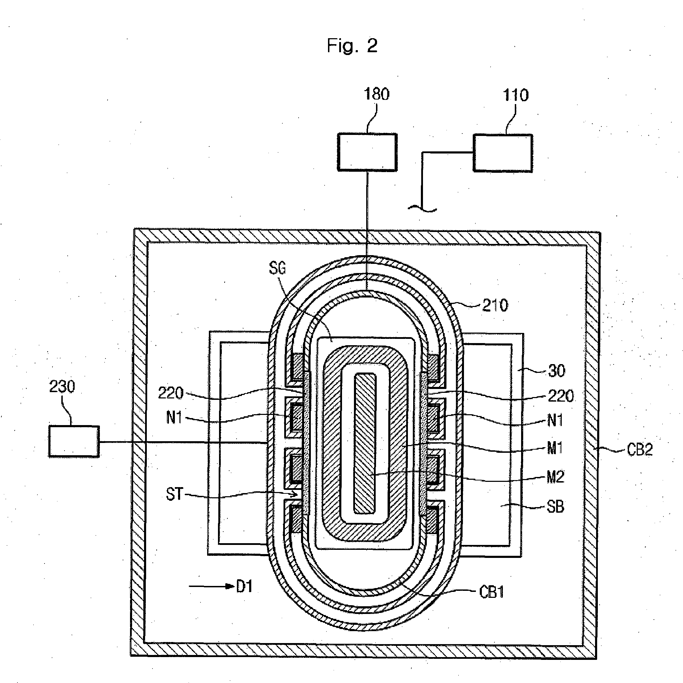

FIG. 1 is a side cross-sectional view showing a thin film deposition apparatus according to an exemplary embodiment of the present invention and FIG. 2 is a horizontal cross-sectional view showing the thin film deposition apparatus shown in FIG. 1.

Referring to FIGS. 1 and 2, a thin film deposition apparatus 500 deposits a thin film on a substrate SB. To this end, the thin film deposition apparatus 500 includes a process chamber CB1, a gas supply unit 180, a substrate transfer chamber CB2, a sputter unit 100, and a plasma generating unit 200.

The process chamber CB1 includes a reaction space 120 therein and is connected to the substrate transfer chamber CB2 that includes a space in which the substrate SB is transferred. The substrate transfer chamber CB2 includes an inlet orifice 51 formed through a side portion of the substrate transfer chamber CB2 and an outlet orifice 52 formed through the other side portion of the substrate transfer chamber CB2. Accordingly, the substrate SB is loaded into the substrate transfer chamber CB2 through the inlet orifice 51, and the substrate SB is discharged outside the substrate transfer chamber CB2 through the outlet orifice 52 after the thin film is deposited on the substrate SB.

In the present exemplary embodiment, a substrate supporter 30 that supports the substrate SB in the substrate transfer chamber CB2 may move to a first direction D1 and an opposite direction to the first direction D1 by a driver unit 20. Thus, the substrate SB may be transferred to a position adjacent to the inlet orifice 51 or the outlet orifice 52 by the driver unit 20, so that a substrate transfer robot (not shown) located at a position outside the substrate transfer chamber CB2 places the substrate SB on the substrate supporter 30 or picks the substrate SB from the substrate supporter 30.

In addition, when the substrate supporter 30 is moved in the first direction D1 by the driver 20 while the thin film deposition apparatus 500 is operated, a material (hereinafter, referred to as sputtered material SM) from a target TG is provided on the substrate SB from an end of the substrate SB to the other end of the substrate SB.

Therefore, the thin film may be uniformly deposited over the substrate SB.

The plasma generating unit 200 generates plasma PM in the reaction space 120. In the present exemplary embodiment, the plasma generating unit 200 generates the plasma PM using an induction field. For instance, the plasma generating unit 200 of embodiments of the invention may be, but not limited to, an electron cyclone resonance (ECR) plasma generating unit or an inductively coupled plasma (ICP) generating unit. The above-mentioned plasma generating units generate the plasma PM using the induction field instead of using two electrodes applied with a bias voltage, and thus the above-mentioned plasma generating units may be called an electrodeless-type plasma generating unit. However, the plasma generating unit 200 of embodiments of the invention are not be limited to the above-mentioned plasma generating units. That is, the plasma generating unit 200 of other embodiments of the invention may be one of plasma generating units that generate the plasma using an electric field formed between two electrodes applied with a direct current voltage or a radio frequency (RF) voltage.

FIGS. 1 and 2 show the electron cyclone resonance (ECR) plasma as an example of the plasma generating unit 200 according to an embodiments of the invention, and hereinafter, the plasma generating unit 200 will be described in detail.

The plasma generating unit 200 includes the gas supply unit 180, an electromagnetic wave generating unit 230, a wave guide 210, a first magnet N1, a second magnet N2, and a dielectric plate 220.

The gas supply unit 180 is connected to the process chamber CB1 to provide gas to the reaction space 120 and the gas includes a source material required to generate the plasma PM. In the present exemplary embodiment, the gas may include an inert gas such as argon gas.

The electromagnetic wave generating unit 230 receives a source voltage from the outside and generates an electromagnetic wave such as a microwave. The electromagnetic wave generating unit 230 is connected to the wave guide 210, and thus the electromagnetic wave is transferred to the wave guide 210. The electromagnetic wave generated by the electromagnetic wave generating unit 230 flows in the wave guide 210. A plurality of slot antennas ST is formed on the wave guide 210, which leads to the reaction space 120. In other words, the slot antenna ST is connected to the reaction space 120. Thus, the electromagnetic wave flowing through the wave guide 210 travels toward the reaction space 120 through the slot antennas ST.

In the present exemplary embodiment, the wave guide 210 has a shape surrounding the process chamber CB1 when viewed in a plan view. In this case, the slot antennas ST are disposed to be spaced apart from each other in a longitudinal direction of the process chamber CB1.

The first and second magnets N1 and N2 are disposed adjacent to each slot antenna ST, and the dielectric plate 220 includes a ceramic material such as alumina and is located in a path through which the electromagnetic wave travels to the reaction space 120 through the slot antennas ST. Accordingly, the induction field is scattered from the electromagnetic wave, so that the plasma PM is generated from the inert gas provided into the reaction space 120.

In addition, in the present exemplary embodiment, when the electromagnetic wave is the microwave having a frequency of about 2.45 MHz and a magnetic field formed by the first and second magnets N1 and N2 has an intensity of about 0.0875 T (875 Gauss), the electron cyclone resonance is generated in the reaction space 120, and thus the plasma PM may be easily formed from the inert gas.

The sputtering unit 100 sputters the target TG using the plasma PM formed in the reaction space 120 by the plasma generating unit 200. In the embodiments of the invention, the sputtering unit 100 may be, but not limited to, a magnetron sputtering unit.

The sputtering unit 100 includes a source voltage generator 110, the target TG, a magnetron sputtering gun SG, a substrate supporter 30, and S-pole magnet M1 and N-pole magnet M2 disposed in the magnetron sputtering gun SG. When viewed in a plan view, the N-pole magnet M2 is spaced apart from the S-pole magnet M1 and the S-pole magnet M1 surrounds the N-pole magnet M2. The electromagnetic field formed by the S-pole and N-pole magnets M1 and M2 improves ionization efficiency of the plasma PM, thereby increasing a sputtering efficiency of the target TG.

The source voltage generator 110 applies a bias voltage to the target TG coupled to the magnetron sputtering gun SG. In this case, the target TG serves as a first electrode in the sputtering unit 100 and the substrate supporter 30 disposed under the substrate SB to support the substrate SB serves as a second electrode. Thus, after the plasma PM is formed in the reaction space 120 by the plasma generating unit 200, positive ions of the plasma PM are collided with the target TG using an electric field EF generated between the first electrode and the second electrode, so that the sputtered material SM from the target TG is deposited on the substrate SB. As a result, the thin film may be formed on the substrate SB.

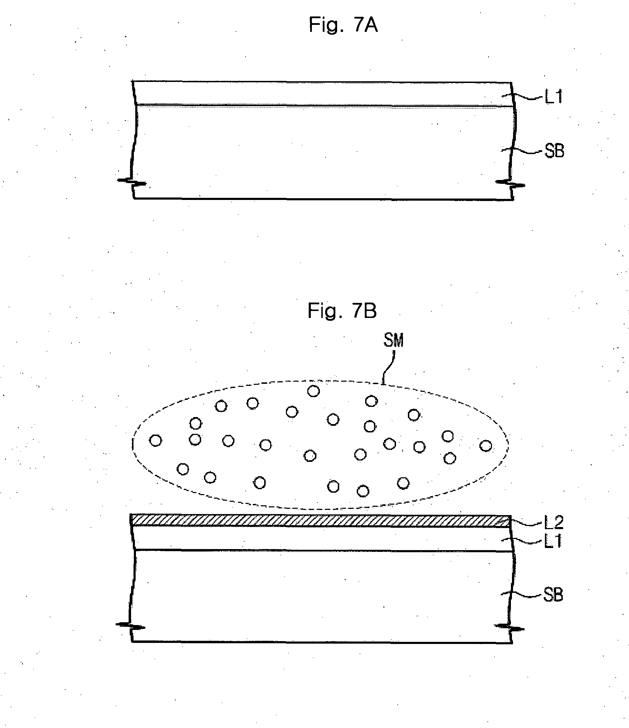

Meanwhile, in the above-described thin film deposition apparatus 500, the plasma generating unit 200 is driven by the electromagnetic wave generating unit 230 and the sputter unit 100 is driven by the source voltage generator 110. Accordingly, the sputtering unit 100 and the plasma generating unit 200 may be independently driven from each other, and thus the bias voltage used to drive the sputtering unit 100 may be controlled regardless of the drive of the plasma generating unit 200 to form the plasma PM. Therefore, the bias voltage may be reduced to prevent the previously formed thin film on the substrate SB from being damaged by the sputtered material SM. This will be described in detail with reference to FIGS. 7A and 7B later.

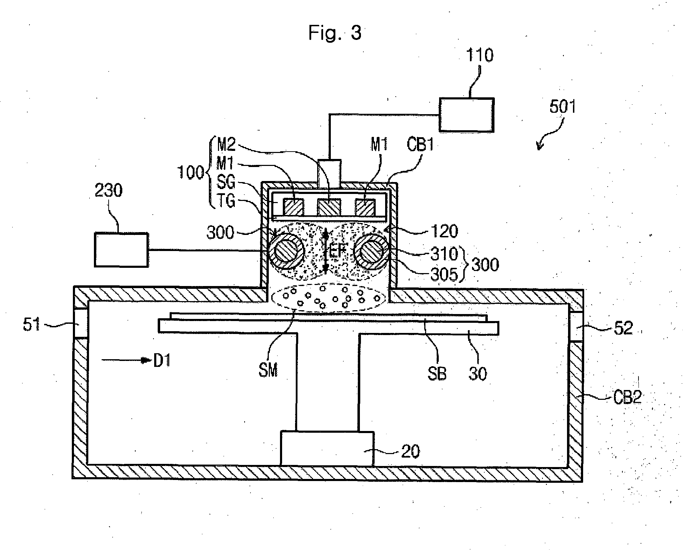

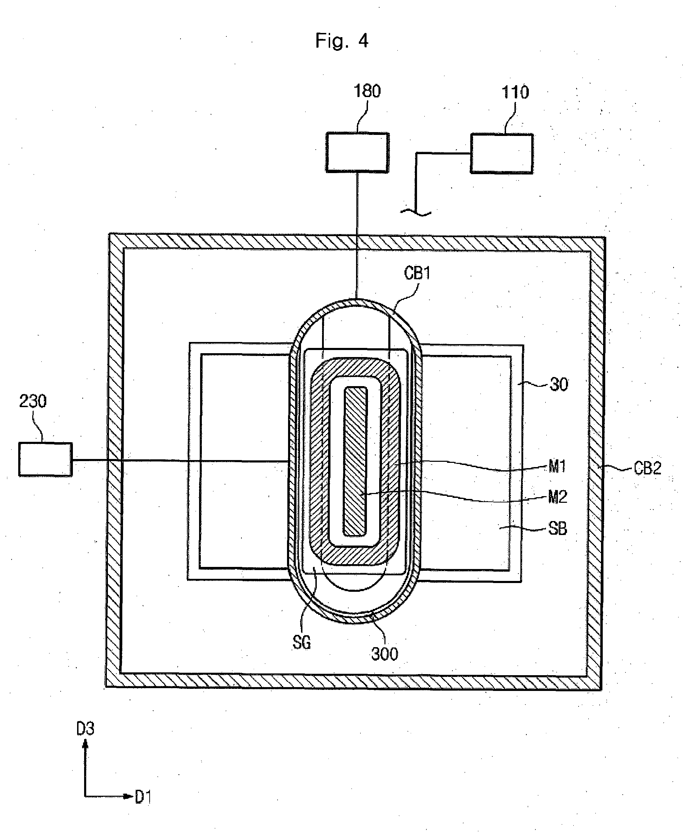

FIG. 3 is a side cross-sectional view showing a thin film deposition apparatus according to another exemplary embodiment of the present invention and FIG. 4 is a horizontal cross-sectional view showing the thin film deposition apparatus shown in FIG. 3. In FIGS. 3 and 4, the same reference numerals denote the same elements in FIGS. 1 and 2, and thus detailed descriptions of the same elements will be omitted.

Referring to FIG. 3, the thin film deposition apparatus 501 includes a sputtering unit 100 and a plasma generating unit 300. In the present exemplary embodiment shown in FIG. 3, the plasma generating unit 300 is the inductively coupled plasma generating unit.

The plasma generating unit 300 includes an electromagnetic wave generating unit 230 that generates an electromagnetic wave, an antenna 310 applied with the electromagnetic wave, and a dielectric layer 305 that covers the surface of the antenna 310. The antenna 310 covered by the dielectric layer 305 has a U shape when viewed in a plan view and is disposed in the process chamber CB1.

According to the plasma generating unit 300, the electromagnetic wave generated by the electromagnetic wave generating unit 230 is provided to the antenna 310 and the electromagnetic wave flowing along the antenna 310 passes through the dielectric layer 305. Thus, the induction field is generated in the reaction space 120 according to the Lentz law. As a result, the plasma PM may be formed from the inert gas provided into the reaction space 120 by the induction field.

Therefore, as the thin film deposition apparatus 500 shown in FIGS. 1 and 2, the sputtering unit 100 and the plasma generating unit 300 shown in FIGS. 3 and 4 may be independently driven from each other, and thus the bias voltage used to drive the sputtering unit 100 may be controlled regardless of the drive of the plasma generating unit 300 to form the plasma PM. Therefore, the bias voltage may be reduced to prevent the previously formed thin film on the substrate SB from being damaged by the sputtered material SM.

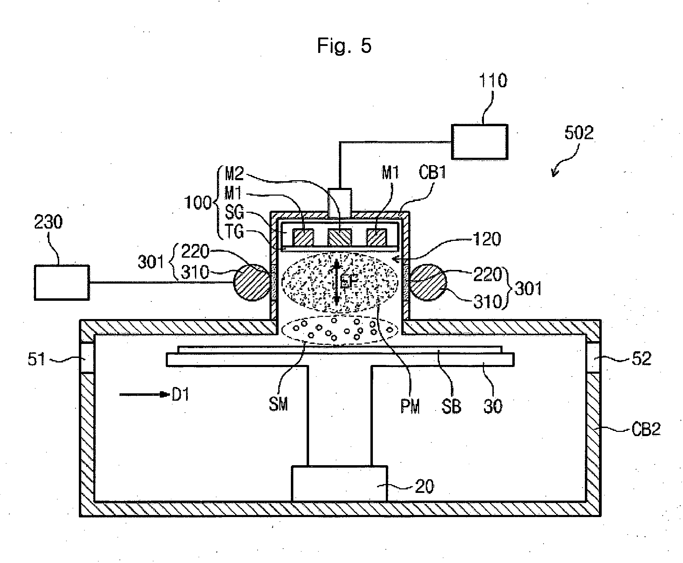

FIG. 5 is a side cross-sectional view showing a thin film deposition apparatus according to another exemplary embodiment of the present invention. In FIG. 5, the same reference numerals denote the same elements in FIGS. 3 and 4, and thus detailed descriptions of the same elements will be omitted.

Referring to FIG. 5, the thin film deposition apparatus 502 includes a sputtering unit 100 and a plasma generating unit 301. In the present exemplary embodiment, the plasma generating unit 301 may be the inductively coupled plasma generating unit as the plasma generating unit 300 shown in FIG. 4.

The plasma generating unit 301 includes an electromagnetic wave generating unit 230 that generates an electromagnetic wave, an antenna 310 applied with the electromagnetic wave, and a dielectric plate 220. In the present exemplary embodiment, as the shape of the wave guide 210 shown in FIG. 1, the antenna 310 is disposed to surround the process chamber CB1 when viewed in a plan view, and the dielectric plate 220 is located in a path through which the electromagnetic wave flowing along the antenna 310 travels to the reaction space 120 of the process chamber CB1. Accordingly, the plasma generating unit 301 may generate the plasma PM in the reaction space 120 as similar to the plasma generating unit 300 described with reference to FIGS. 3 and 4.

As the thin film deposition apparatus 501 shown in FIGS. 3 and 4, the sputtering unit 100 and the plasma generating unit 301 of the thin film deposition apparatus 502 may be independently driven from each other, and thus the bias voltage used to drive the sputtering unit 100 may be controlled regardless of the drive of the plasma generating unit 301 to form the plasma PM. Therefore, the bias voltage may be reduced to prevent the previously formed thin film on the substrate SB from being damaged by the sputtered material SM.

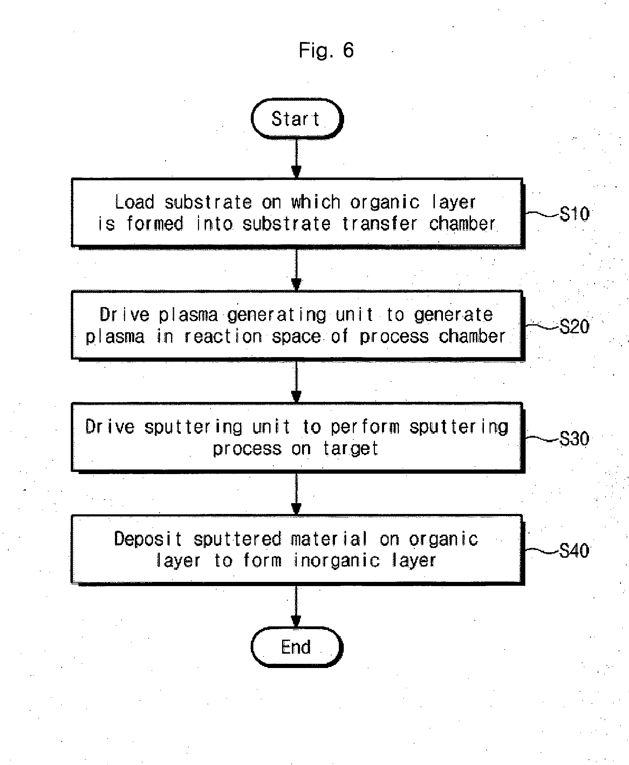

FIG. 6 is a flowchart showing a method of depositing a thin film on a substrate according to an exemplary embodiment of the present invention, FIG. 7A is a view showing a substrate before a thin film is deposited thereon, and FIG. 7B is a view showing a substrate after a thin film is deposited thereon.

Referring to FIGS. 1, 6, 7A, and 7B, the substrate SB on which an organic layer L1 is formed is loaded into the substrate transfer chamber CB2 (S10). In this case, the substrate SB may be loaded into the substrate transfer chamber CB2 through the inlet orifice 51 by the substrate transfer robot (not shown) located at a position outside the substrate transfer chamber CB2.

Then, the plasma generating unit 200 is driven to form the plasma PM in the reaction space 120 of the process chamber CB1 (S20). As described with reference to FIGS. 1 and 2, the plasma generating unit 100 may form the plasma PM using the electromagnetic wave generated by the electromagnetic generating unit 230.

After the plasma PM is formed in the reaction space 120, the sputtering unit 200 is driven to allow the plasma PM to sputter the target TG (S30). In detail, the bias voltage is applied to the target TG by the source voltage generated by the source voltage generator 110 of the sputtering unit 200, and thus the electric field EF is generated in the reaction space 120. Accordingly, the positive ions of the plasma PM sputter the target TG including an inorganic material.

As described above, when the target TG is sputtered by driving the plasma generating unit 100 and the sputtering unit 200, the sputtered material SM from the target TG is deposited on the organic layer L1. Therefore, an inorganic layer L2 may be formed on the organic layer L1 with the inorganic material.

Meanwhile, as described with reference to FIGS. 1 and 2, the sputtering unit 100 and the plasma generating unit 200 may be independently driven from each other. Accordingly, the bias voltage used to drive the sputtering unit 100 may be controlled regardless of the drive of the plasma generating unit 200 to form the plasma PM. Therefore, the bias voltage may be reduced to prevent the previously formed organic layer L1 on the substrate SB from being damaged when the inorganic layer L2 is formed by depositing the sputtered material SM on the substrate SB.

According to a conventional sputtering unit that forms the plasma using the electric field generated between the anode and the cathode, which are disposed in the reaction space of a chamber, and sputters the target using plasma ions accelerated by the electric field, the bias voltage having the high voltage level is required to be applied to the anode and the cathode. For instance, when a pressure in the chamber is maintained at a few mTorr (i.e. a few tenths of Pa) and a distance between the target and the substrate is about 10cm, the high voltage of about 100 volts is applied to the anode and the cathode to form the plasma in the chamber and the sputtering process is performed by using the anode and the cathode applied the bias voltage having the high voltage level.

As described above, however, in the present exemplary embodiments, the bias voltage used to drive the sputtering unit 100 is controlled regardless of the drive of the plasma generating unit 200 to form the plasma PM. Accordingly, although the process chamber is under the same conditions as those of the conventional chamber, the bias voltage applied to the sputtering unit 100 may be reduced to about 10 volts to about 50 volts.

Thus, particles sputtered from the target TG, e.g., neutral argon atoms, negative oxygen ions, etc., may be prevented from being provided to the substrate SB, which have excessive energy caused by the bias voltage, while the sputtering process is performed using the sputtering unit 100. Consequently, defects may be prevented from occurring on the previously formed organic layer L1 on the substrate SB before the sputtering process is performed.

In addition, as the exemplary embodiments described above, in the case that the sputtering unit 100 is the electron cyclone resonance (ECR) plasma generating unit or the inductively coupled plasma (ICP) generating unit, which generates the plasma PM using the induction field, a density of the plasma generated by the plasma generating unit using the induction field is about ten times to about one hundred times greater than a density of the plasma generated by a capacitively coupled plasma generating unit provided in the conventional sputtering unit. Thus, according to the exemplary embodiments, since the bias voltage applied to the sputtering unit 100 is reduced to about 10 volts to about 50 volts and the density of the plasma generated by the sputtering unit 100 is improved, the sputtering efficiency may be increased.

Although the exemplary embodiments of the present invention have been described, it is understood that the present invention should not be limited to these exemplary embodiments but various changes and modifications can be made by one ordinary skilled in the art within the scope of the present invention as hereinafter claimed. 1

## Claims

1. A thin film deposition apparatus comprising:
a process chamber (CB1) that includes a reaction space (120);
a plasma generating unit (200) arranged to generate a plasma in the reaction space (120); and
a sputtering unit (100) arranged to form an electric field in the reaction space (120) and arranged to perform a sputtering process on a target using the plasma, wherein the sputtering unit (100) is independently driven from the plasma generating unit (200);
wherein the plasma generating unit (200) comprises:
a gas supply unit (180) arranged to provide a gas used to generate the plasma into the reaction space (120);
an electromagnetic wave generating unit (230) arranged to generate electromagnetic waves;
a wave guide (210) connected to the electromagnetic wave generating unit (230);
a plurality of slot antennas formed on the wave guide (216), slot antennas being spaced apart from each other and connected to the reaction space (120), wherein the electromagnetic waves are arranged to pass through the slot antennas; and
a plurality of magnets disposed adjacent to the slot antennas, the magnets being arranged to form a magnetic field in a path through which the electromagnetic waves pass.

2. The thin film deposition apparatus of claim 1, wherein the plasma generating unit (200) includes an electrodeless-type plasma generating unit.

3. The thin film deposition apparatus of claim 1 or 2, wherein the plasma generating unit (200) is arranged to generate the plasma using an induction field.

4. The thin film deposition apparatus of claim 3, wherein the plasma generating unit (200) includes an electron cyclone resonance plasma generating unit.

5. The thin film deposition apparatus of any one of claims 1 to 4, wherein the wave guide (210) is arranged to surround the process chamber.

6. The thin film deposition apparatus of claim 3, wherein the plasma generating unit (200) includes an inductively coupled plasma generating unit.

7. The thin film deposition apparatus of any one of claims 1 to 6, wherein the sputtering unit (100) comprises:
a source voltage generator (110) arranged to generate a bias voltage;
a first electrode arranged to be applied with the bias voltage; and
a second electrode facing the first electrode while interposing the reaction space therebetween, the second electrode being arranged to form an electric field together with the first electrode; optionally wherein the sputtering unit includes a magnetron sputtering unit.

8. The thin film deposition apparatus of any one of claims 1 to 7, further comprising:
a substrate transfer chamber coupled to the process chamber such that an inner portion of the substrate transfer chamber is connected to the reaction space (120), the substrate transfer chamber comprising a substrate transfer space, into which a substrate to be deposited with a sputtered material supplied from the target by the sputtering unit (100), is transferred.

9. A method of depositing a thin film on a substrate using a thin film deposition apparatus including a process chamber, comprising:
driving a plasma generating unit (200) of the thin film deposition apparatus to generate a plasma in a reaction space (20) of the process chamber;
driving a sputtering unit (100) of the thin film deposition apparatus to sputter a target using the plasma; and
depositing a sputtered material from the target on the substrate;
wherein the plasma generating unit (200) and the sputtering unit (100) are independently driven from each other;
wherein the plasma generating unit (200) comprises:
a gas supply unit (180) arranged to provide a gas used to generate the plasma into the reaction space (120);
an electromagnetic wave generating unit (230) arranged to generate electromagnetic waves;
a wave guide (210) connected to the electromagnetic wave generating unit (230);
a plurality of slot antennas formed on the wave guide (210), the slot antennas being spaced apart from each other and connected to the reaction space (120), wherein the electromagnetic waves are arranged to pass through the slot antennas; and
a plurality of magnets disposed adjacent to the slot antennas, the magnets being arranged to form a magnetic field in a path through which the electromagnetic waves pass.

10. The method of claim 9, wherein the plasma generating unit (200) generates the plasma using an induction field.

11. The method of claim 9, wherein the plasma generating unit (200) applies an electron cyclone resonance to an electric field to generate the plasma.

12. The method of any one of claims 9 to 11, further comprising:
loading the substrate into the reaction space (120) before the plasma generating unit (200) and the sputtering unit (100) are driven, wherein the substrate comprises an organic layer formed thereon before being loaded into the reaction space and the organic layer is exposed to the reaction space; optionally wherein the target comprises an inorganic material, and an inorganic layer is formed on the organic layer after the depositing a sputtered material.

## Patentansprüche

1. Dünnschichtaufbringungsvorrichtung, umfassend:
eine Prozesskammer (CB1), die einen Reaktionsraum (120) hat,
eine Plasmaerzeugungseinheit (200), die zur Erzeugung eines Plasmas im Reaktionsraum (120) ausgestaltet ist, und
eine Sputtereinheit (100), die zum Bilden eines elektrischen Felds im Reaktionsraum (120) ausgestaltet ist und zur Durchführung eines Sputterverfahrens an einem Target unter Verwendung des Plasmas ausgestaltet ist, wobei die Sputtereinheit (100) unabhängig von der Plasmaerzeugungseinheit (200) angetrieben wird,
wobei die Plasmaerzeugungseinheit (200) umfasst:
eine Gaszufuhreinheit (180), die zum Liefern eines zur Erzeugung des Plasmas verwendeten Gases in den Reaktionsraum (120) ausgestaltet ist,
eine Erzeugungseinheit für elektromagnetische Wellen (230), die zur Erzeugung von elektromagnetischen Wellen ausgestaltet ist,
einen Wellenleiter (210), der mit der Erzeugungseinheit für elektromagnetische Wellen (230) verbunden ist,
mehrere Schlitzantennen, die an dem Wellenleiter (210) ausgebildet sind, wobei die Schlitzantennen voneinander beabstandet und mit dem Reaktionsraum (120) verbunden sind, wobei die elektromagnetischen Wellen ausgestaltet sind, um durch die Schlitzantennen hindurch zu verlaufen, und
mehrere Magnete, die neben den Schlitzantennen liegend angeordnet sind, wobei die Magnete zum Bilden eines Magnetfelds in einem Weg ausgestaltet sind, durch den die elektromagnetischen Wellen verlaufen.

2. Dünnschichtaufbringungsvorrichtung nach Anspruch 1, wobei die Plasmaerzeugungseinheit (200) eine Plasmaerzeugungseinheit des elektrodenlosen Typs beinhaltet.

3. Dünnschichtaufbringungsvorrichtung nach Anspruch 1 oder 2, wobei die Plasmaerzeugungseinheit (200) zur Erzeugung des Plasmas unter Verwendung eines Induktionsfelds ausgestaltet ist.

4. Dünnschichtaufbringungsvorrichtung nach Anspruch 3, wobei die Plasmaerzeugungseinheit (200) eine Elektron-Zyklotron-Resonanz-Plasmaerzeugungseinheit beinhaltet.

5. Dünnschichtaufbringungsvorrichtung nach einem der Ansprüche 1 bis 4, wobei der Wellenleiter (210) ausgestaltet ist, um die Prozesskammer zu umgeben.

6. Dünnschichtaufbringungsvorrichtung nach Anspruch 3, wobei die Plasmaerzeugungseinheit (200) eine induktiv gekoppelte Plasmaerzeugungseinheit beinhaltet.

7. Dünnschichtaufbringungsvorrichtung nach einem der Ansprüche 1 bis 6, wobei die Sputtereinheit (100) umfasst:
einen Quellspannungsgenerator (110), der zur Erzeugung einer Vorspannung ausgestaltet ist,
eine erste Elektrode, die zum Anlegen der Vorspannung an sie ausgestaltet ist, und
eine zweite Elektrode, die der ersten Elektrode zugekehrt ist, während sie den Reaktionsraum dazwischenliegend anordnet, wobei die zweite Elektrode ausgestaltet ist, um zusammen mit der ersten Elektrode ein elektrisches Feld zu bilden, wobei die Sputtereinheit wahlweise eine Magnetronsputtereinheit beinhaltet.

8. Dünnschichtaufbringungsvorrichtung nach einem der Ansprüche 1 bis 7, die ferner aufweist:
eine Substratübertragungskammer, die mit der Prozesskammer gekoppelt ist, so dass ein innerer Teil der Substratübertragungskammer mit dem Reaktionsraum (120) verbunden ist, wobei die Substratübertragungskammer einen Substratübertragungsraum aufweist, in welchen ein Substrat übertragen wird, auf welches ein durch die Sputtereinheit (100) von dem Target geliefertes gesputtertes Material aufzubringen ist.

9. Verfahren zum Aufbringen einer Dünnschicht auf ein Substrat unter Verwendung einer Dünnschichtaufbringungsvorichtung, die eine Prozesskammer beinhaltet, umfassend:
Antreiben einer Plasmaerzeugungseinheit (200) der Dünnschichtaufbringungsvorrichtung zur Erzeugung eines Plasmas in einem Reaktionsraum (120) der Prozesskammer,
Antreiben einer Sputtereinheit (100) der Dünnschichtaufbringungsvorrichtung zum Sputtern eines Targets unter Verwendung des Plasmas und
Aufbringen eines gesputterten Materials von dem Target auf dem Substrat,
wobei die Plasmaerzeugungseinheit (200) und die Sputtereinheit (100) unabhängig voneinander angetrieben werden,
wobei die Plasmaerzeugungseinheit (200) umfasst:
eine Gaszufuhreinheit (180), die zum Liefern eines zur Erzeugung des Plasmas verwendeten Gases in den Reaktionsraum (120) ausgestaltet ist,
eine Erzeugungseinheit für elektromagnetische Wellen (230), die zur Erzeugung von elektromagnetischen Wellen ausgestaltet ist,
einen Wellenleiter (210), der mit der Erzeugungseinheit für elektromagnetische Wellen (230) verbunden ist,
mehrere Schlitzantennen, die an dem Wellenleiter (210) ausgebildet sind, wobei die Schlitzantennen voneinander beabstandet und mit dem Reaktionsraum (120) verbunden sind, wobei die elektromagnetischen Wellen ausgestaltet sind, um durch die Schlitzantennen hindurch zu verlaufen, und
mehrere Magnete, die neben den Schlitzantennen liegend angeordnet sind, wobei die Magnete zum Bilden eines Magnetfelds in einem Weg ausgestaltet sind, durch den die elektromagnetischen Wellen verlaufen.

10. Verfahren nach Anspruch 9, wobei die Plasmaerzeugungseinheit (200) das Plasma unter Verwendung eines Induktionsfelds erzeugt.

11. Verfahren nach Anspruch 9, wobei die Plasmaerzeugungseinheit (200) zur Erzeugung des Plasmas eine Elektron-Zyklotron-Resonanz auf ein elektrisches Feld anwendet.

12. Verfahren nach einem der Ansprüche 9 bis 11, das ferner aufweist:
Laden des Substrats in den Reaktionsraum (120), bevor die Plasmaerzeugungseinheit (200) und die Sputtereinheit (100) angetrieben werden, wobei das Substrat eine organische Schicht aufweist, die daran ausgebildet wird, bevor es in den Reaktionsraum geladen wird, und die organische Schicht dem Reaktionsraum ausgesetzt wird, wobei das Target wahlweise ein anorganisches Material umfasst und nach der Aufbringung eines gesputterten Materials eine anorganische Schicht auf der organischen Schicht ausgebildet wird.

## Revendications

1. Appareil de dépôt de film mince comportant :
une chambre de traitement (CB1) qui comprend un espace de réaction (120) ;
une unité de génération de plasma (200) agencée pour générer un plasma dans l'espace de réaction (120) ; et
une unité de pulvérisation (100) agencée pour former un champ électrique dans l'espace de réaction (120) et agencée pour effectuer un procédé de pulvérisation sur une cible en utilisant le plasma, dans lequel l'unité de pulvérisation (100) est entraînée de manière indépendante par rapport à l'unité de génération de plasma (200) ;
dans lequel l'unité de génération de plasma (200) comporte :
une unité d'alimentation en gaz (180) agencée pour fournir un gaz utilisé pour générer le plasma dans l'espace de réaction (120) ;
une unité de génération d'ondes électromagnétiques (230) agencée pour générer des ondes électromagnétiques ;
un guide d'ondes (210) connecté à l'unité de génération d'ondes électromagnétiques (230) ;
une pluralité d'antennes à fentes formées sur le guide d'ondes (210), les antennes à fentes étant espacées les unes par rapport aux autres et connectées à l'espace de réaction (120), dans lequel les ondes électromagnétiques sont agencées pour traverser les antennes à fentes ; et
une pluralité d'aimants disposés de manière adjacente par rapport aux antennes à fentes, les aimants étant agencés pour former un champ magnétique dans une trajectoire que traversent les ondes électromagnétiques.

2. Appareil de dépôt de film mince selon la revendication 1, dans lequel l'unité de génération de plasma (200) comprend une unité de génération de plasma du type sans électrode.

3. Appareil de dépôt de film mince selon la revendication 1 ou la revendication 2, dans lequel l'unité de génération de plasma (200) est agencée pour générer le plasma en utilisant un champ d'induction.

4. Appareil de dépôt de film mince selon la revendication 3, dans lequel l'unité de génération de plasma (200) comprend une unité de génération de plasma du type à résonance cyclotronique des électrons.

5. Appareil de dépôt de film mince selon l'une quelconque des revendications 1 à 4, dans lequel le guide d'ondes (210) est agencé pour entourer la chambre de traitement.

6. Appareil de dépôt de film mince selon la revendication 3, dans lequel l'unité de génération de plasma (200) comprend une unité de génération de plasma du type à couplage par induction.

7. Appareil de dépôt de film mince selon l'une quelconque des revendications 1 à 6, dans lequel l'unité de pulvérisation (100) comporte :
un générateur de tension de source (110) agencé pour générer une tension de polarisation ;
une première électrode agencée pour faire l'objet d'une application de la tension de polarisation ; et
une deuxième électrode orientée vers la première électrode tout en intercalant l'espace de réaction entre elles, la deuxième électrode étant agencée pour former un champ électrique avec la première électrode ; éventuellement dans lequel l'unité de pulvérisation comprend une unité de pulvérisation du type à magnétron.

8. Appareil de dépôt de film mince selon l'une quelconque des revendications 1 à 7, comportant en outre :
une chambre de transfert de substrat accouplée à la chambre de traitement de telle sorte qu'une partie intérieure de la chambre de transfert de substrat est connectée à l'espace de réaction (120), la chambre de transfert de substrat comportant un espace de transfert de substrat, dans lequel est transféré un substrat devant faire l'objet d'un dépôt de matériau pulvérisé fourni en provenance de la cible par l'unité de pulvérisation (100).

9. Procédé de dépôt d'un film mince sur un substrat au moyen d'un appareil de dépôt de film mince comprenant une chambre de traitement, comportant :
l'étape consistant à entraîner une unité de génération de plasma (200) de l'appareil de dépôt de film mince à générer un plasma dans un espace de réaction (120) de la chambre de traitement ;
l'étape consistant à entraîner une unité de pulvérisation (100) de l'appareil de dépôt de film mince à pulvériser une cible en utilisant le plasma ; et
l'étape consistant à déposer un matériau pulvérisé en provenance de la cible sur le substrat ;
dans lequel l'unité de génération de plasma (200) et l'unité de pulvérisation (100) sont entraînées de manière indépendante l'une par rapport à l'autre ;
dans lequel l'unité de génération de plasma (200) comporte :
une unité d'alimentation en gaz (180) agencée pour fournir un gaz utilisé pour générer le plasma dans l'espace de réaction (120) ;
une unité de génération d'ondes électromagnétiques (230) agencée pour générer des ondes électromagnétiques ;
un guide d'ondes (210) connecté à l'unité de génération d'ondes électromagnétiques (230) ;
une pluralité d'antennes à fentes formées sur le guide d'ondes (210), les antennes à fentes étant espacées les unes par rapport aux autres et connectées à l'espace de réaction (120), dans lequel les ondes électromagnétiques sont agencées pour traverser les antennes à fentes ; et
une pluralité d'aimants disposés de manière adjacente par rapport aux antennes à fentes, les aimants étant agencés pour former un champ magnétique dans une trajectoire que traversent les ondes électromagnétiques.

10. Procédé selon la revendication 9, dans lequel l'unité de génération de plasma (200) génère le plasma en utilisant un champ d'induction.

11. Procédé selon la revendication 9, dans lequel l'unité de génération de plasma (200) applique une résonance cyclotronique des électrons sur un champ électrique pour générer le plasma.

12. Procédé selon l'une quelconque des revendications 9 à 11, comportant en outre :
l'étape consistant à charger le substrat dans l'espace de réaction (120) avant d'entraîner l'unité de génération de plasma (200) et l'unité de pulvérisation (100), dans lequel le substrat comporte une couche organique formée sur celui-ci avant tout chargement dans l'espace de réaction et la couche organique est exposée à l'espace de réaction ; éventuellement dans lequel la cible comporte un matériau inorganique, et une couche inorganique est formée sur la couche organique après le dépôt d'un matériau pulvérisé.
